(19)

Europäisches Patentamt

European Patent Office

Office européen des brevets

(11) **EP 4 411 031 A1**

(12) **EUROPEAN PATENT APPLICATION**
published in accordance with Art. 153(4) EPC

(43) Date of publication:
**07.08.2024 Bulletin 2024/32**

(21) Application number: **22876069.0**

(22) Date of filing: **22.09.2022**

(51) International Patent Classification (IPC):
***C30B 29/42*** *(2006.01)*          ***C30B 29/40*** *(2006.01)*

(52) Cooperative Patent Classification (CPC):
**C30B 29/40; C30B 29/42**

(86) International application number:
**PCT/JP2022/035510**

(87) International publication number:
**WO 2023/054202 (06.04.2023 Gazette 2023/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.09.2021 JP 2021159962
21.09.2022 JP 2022150699**

(71) Applicant: **DOWA Electronics Materials Co., Ltd.
Tokyo 101-0021 (JP)**

(72) Inventors:
• **SUNACHI, Naoya
Tokyo 101-0021 (JP)**
• **TOBA, Ryuichi
Tokyo 101-0021 (JP)**
• **AKAISHI, Akira
Tokyo 101-0021 (JP)**

(74) Representative: **Müller-Boré & Partner
Patentanwälte PartG mbB
Friedenheimer Brücke 21
80639 München (DE)**

(54) **GAAS WAFER, GAAS WAFER GROUP, AND METHOD FOR PRODUCING GAAS INGOT**

(57)     Provided is a GaAs wafer having suppressed carrier concentration and low dislocation density, as well as a large proportion of the area of a region with zero dislocation density to the GaAs wafer surface. The GaAs wafer has a silicon concentration of $1.0 \times 10^{17}$ cm$^{-3}$ or more and less than $1.1 \times 10^{18}$ cm$^{-3}$; an indium concentration of $3.0 \times 10^{18}$ cm$^{-3}$ or more and less than $3.0 \times 10^{19}$ cm$^{-3}$; a boron concentration of $2.5 \times 10^{18}$ cm$^{-3}$ or more; a carrier concentration of $1.0 \times 10^{16}$ cm$^{-3}$ or more and $4.0 \times 10^{17}$ cm$^{-3}$ or less; and a proportion of the area of a region with zero dislocation density to the wafer surface of 91.0% or more.

*FIG. 4*

EP 4 411 031 A1

**Description**

TECHNICAL FIELD

This disclosure relates to a GaAs wafer, a GaAs wafer group, and a method of producing a GaAs ingot.

BACKGROUND

As a method of producing a GaAs crystal (ingot) to obtain a GaAs single crystal wafer (hereinafter, also referred to as a GaAs wafer), a pulling (LEC) method, a horizontal boat (HB) method, a vertical gradient freezing (VGF) method, and a vertical Bridgman (VB) method are known. The ingot is a mass having a straight body portion of a single crystal grown by such a production method, starting from a seed crystal of the single crystal. The wafer is cut out from the straight body portion of the ingot. A plurality of GaAs wafers are obtained from an identical GaAs ingot, and these plurality of wafers are also referred to as a wafer group.

Of these production methods, the vertical gradient freezing (VGF) method and the vertical Bridgman (VB) method are known as methods that enable low dislocation density.

For example, Patent Literature (PTL) 1 discloses an n-type gallium arsenide substrate formed using the VGF method or the VB method, the n-type gallium arsenide substrate having an average dislocation density of less than 100 $cm^{-2}$ and a silicon concentration of $5 \times 10^{16}$ $cm^{-3}$ or more and less than $5 \times 10^{17}$ $cm^{-3}$.

PTL 2 discloses an n-type GaAs ingot formed using the VGF method or the VB method. The n-type GaAs ingot has a charge carrier concentration with a carrier concentration of $1 \times 10^{16}$ $cm^{-3}$ or more and $1 \times 10^{18}$ $cm^{-3}$ or less, and a boron concentration of $5 \times 10^{17}$ $cm^{-3}$ or more, has an etch pit density at a cross-sectional surface perpendicular to the crystal axis of 1500 $cm^{-2}$ or less, and seeks to achieve a very low optical absorption coefficient in the near-infrared region.

CITATION LIST

Patent Literature

    PTL 1: JP2011148693A
    PTL 2: JP2015078122A

SUMMARY

(Technical Problem)

In recent years, of semiconductor lasers, the application of a surface-emitting laser including a vertical cavity surface-emitting laser (VCSEL) is actively advanced, and such a surface-emitting laser is applied to optical communications, optical sensing, etc. In such applications, a silicon doped GaAs wafer is used as an element substrate. The GaAs wafer is required to have suppressed carrier concentration and low dislocation density.

In addition, the dislocation density of the GaAs wafer has a large effect on the characteristics in such applications. Thus, to eliminate the effect, it is desirable that a region with zero dislocation density in the wafer surface is large.

It could be helpful to provide a GaAs wafer and a GaAs wafer group with suppressed carrier concentration and low dislocation density, as well as a large proportion of the area of a region with zero dislocation density to the GaAs wafer surface. It could be further helpful to provide a method of producing a GaAs ingot, from which the GaAs wafer and the GaAs wafer group can be obtained.

(Solution to Problem)

In order to achieve the aforementioned problems, as a result of intensive studies, the inventors focused on the silicon concentration in a crystal growth direction in the production of the GaAs ingot and completed this disclosure as described below.

The main features of this disclosure are as described below.

    (1) A GaAs wafer having:

a silicon concentration of $1.0 \times 10^{17}$ cm$^{-3}$ or more and less than $1.1 \times 10^{18}$ cm$^{-3}$;
an indium concentration of $3.0 \times 10^{18}$ cm$^{-3}$ or more and less than $3.0 \times 10^{19}$ cm$^{-3}$;
a boron concentration of $2.5 \times 10^{18}$ cm$^{-3}$ or more;
a carrier concentration of $1.0 \times 10^{16}$ cm$^{-3}$ or more and $4.0 \times 10^{17}$ cm$^{-3}$ or less; and
a proportion of the area of a region with zero dislocation density to the whole surface of the wafer of 91.0% or more, wherein the proportion of the area of a region with zero dislocation density to the whole surface of the wafer is expressed as a proportion of the number of areas where the number of etch pit counts is 0 to the total number of areas, when, after the wafer surface is pretreated with a sulfuric acid mirror etchant ($H_2SO_4$:$H_2O_2$:$H_2O$ = 3:1:1 (volume ratio)), the wafer surface is immersed in a KOH melt with a liquid temperature of 320°C for 35 minutes to generate etch pits on the wafer surface, a region excluding a toric part with a width of 3 mm from the outer periphery toward the center of the wafer surface from the whole surface of the wafer surface is divided into areas of 1 mm square, and the entire range of each area is then observed with a microscope to count the number of etch pits.

(2) The GaAs wafer according to (1), having an average dislocation density of 250 cm$^{-2}$ or less, wherein the average dislocation density is expressed by a value obtained by, after pretreating the wafer surface with a sulfuric acid mirror etchant ($H_2SO_4$:$H_2O_2$:$H_2O$ = 3:1:1 (volume ratio)), immersing the wafer surface in a KOH melt with a liquid temperature of 320°C for 35 minutes to generate etch pits on the wafer surface, setting 69 or 37 areas with a diameter of 3 mm at regular intervals on the whole surface of the wafer surface, observing each area with a microscope with a field of view diameter of 1.73 mm, searching the field of view where the maximum number of etch pits are observed to count the number of etch pits, determining a converted value obtained by converting the number of counts into a value per unit area (cm$^{-2}$), and then averaging the converted values of the respective areas.

(3) The GaAs wafer according to (1) or (2), wherein the wafer has a size of 3 inches or more.

(4) A GaAs wafer group comprising a plurality of GaAs wafers obtained from a straight body portion of an identical GaAs ingot,
wherein each of the plurality of GaAs wafers has:

a silicon concentration of $1.0 \times 10^{17}$ cm$^{-3}$ or more and less than $1.1 \times 10^{18}$ cm$^{-3}$;
an indium concentration of $3.0 \times 10^{18}$ cm$^{-3}$ or more and less than $3.0 \times 10^{19}$ cm$^{-3}$;
a boron concentration of $2.5 \times 10^{18}$ cm$^{-3}$ or more;
a carrier concentration of $1.0 \times 10^{16}$ cm$^{-3}$ or more and $4.0 \times 10^{17}$ cm$^{-3}$ or less; and
a proportion of the area of a region with zero dislocation density to the whole surface of the wafer of 91.0% or more, and
the proportion of the area of a region with zero dislocation density to the whole surface of the wafer is expressed as a proportion of the number of areas where the number of etch pit counts is 0 to the total number of areas, when, after the wafer surface is pretreated with a sulfuric acid mirror etchant ($H_2SO_4$:$H_2O_2$:$H_2O$ = 3:1:1 (volume ratio)), the wafer surface is immersed in a KOH melt with a liquid temperature of 320°C for 35 minutes to generate etch pits on the wafer surface, a region excluding a toric part with a width of 3 mm from the outer periphery toward the center of the wafer surface from the whole surface of the wafer surface is divided into areas of 1 mm square, and the entire range of each area is then observed with a microscope to count the number of etch pits.

(5) The GaAs wafer group according to (4), wherein each of the plurality of GaAs wafers has an average dislocation density of 250 cm$^{-2}$ or less, and
the average dislocation density is expressed by a value obtained by, after pretreating the wafer surface with a sulfuric acid mirror etchant ($H_2SO_4$:$H_2O_2$:$H_2O$ = 3:1:1 (volume ratio)), immersing the wafer surface in a KOH melt with a liquid temperature of 320°C for 35 minutes to generate etch pits on the wafer surface, setting 69 or 37 areas with a diameter of 3 mm at regular intervals on the whole surface of the wafer surface, observing each area with a microscope with a field of view diameter of 1.73 mm, searching the field of view where the maximum number of etch pits are observed to count the number of etch pits, determining a converted value obtained by converting the number of counts into a value per unit area (cm$^{-2}$), and then averaging the converted values of the respective areas.

(6) The GaAs wafer group according to (5), wherein the plurality of GaAs wafers are obtained from a center portion of the straight body portion of the GaAs ingot and include a wafer having a carrier concentration of less than $2.0 \times 10^{17}$ cm$^{-3}$.

(7) The GaAs wafer group according to any one of (4) to (6), wherein the plurality of wafers are half or more of the total number of wafers obtained from the straight body portion of the identical GaAs ingot.

(8) The GaAs wafer group according to (7), wherein the plurality of wafers are the total number of wafers obtained from a seed side to a tail side of the straight body portion of the identical GaAs ingot.

(9) A method of producing a GaAs ingot by a vertical gradient freezing method or a vertical Bridgman (VB) method, the method using silicon and indium as dopants and using boric oxide as a sealant,
wherein the boric oxide is stirred to lower the silicon concentration at a center portion of a straight body portion of the GaAs ingot than the silicon concentration at a seed side of the straight body portion to cause crystal growth.

(10) The method of producing a GaAs ingot according to (9), wherein the amount of the silicon to be charged is 110 wtppm or more and 150 wtppm or less, and the amount of the indium to be charged is 1000 wtppm or more and 5000 wtppm or less, with respect to the amount of GaAs to be charged into a furnace.

(11) The method of producing a GaAs ingot according to (9) or (10), wherein the amount of the silicon to be charged is 120 wtppm or more and 140 wtppm or less, and the boric oxide contains silicon with 2 mol% or less.

(12) The method of producing a GaAs ingot according to any one of (9) to (11), wherein the stirring has a stirring rate that increases from the seed side toward a tail side of the straight body portion to make the maximum value of the stirring rate 6 rpm or more.

(13) The method of producing a GaAs ingot according to any one of (9) to (12), wherein the silicon concentration at the seed side of the straight body portion is $7.0 \times 10^{17}$ cm$^{-3}$ or more, and the silicon concentration at the center portion of the straight body portion is $6.0 \times 10^{17}$ cm$^{-3}$ or less.

(14) The method of producing a GaAs ingot according to any one of (9) to (13), wherein the carrier concentration at the seed side of the straight body portion of the GaAs ingot is greater than the carrier concentration at the tail side of the straight body portion.

(15) The method of producing a GaAs ingot according to any one of (9) to (14), wherein the center portion of the straight body portion of the GaAs ingot has a part having a carrier concentration of less than $2.0 \times 10^{17}$ cm$^{-3}$.

(Advantageous Effect)

This disclosure provides a GaAs wafer and a GaAs wafer group with suppressed carrier concentration and low dislocation density, as well as a large proportion of the area of a region with zero dislocation density to the GaAs wafer surface. This disclosure further provides a method of producing a GaAs ingot, from which the GaAs wafer and the GaAs wafer group can be obtained.

BRIEF DESCRIPTION OF THE DRAWINGS

In the accompanying drawings:

FIG. 1 is a schematic diagram of a GaAs ingot of this disclosure;
FIG. 2 is a schematic diagram of a 6-inch wafer in which 69 areas are set for measuring the average dislocation density;
FIG. 3 is a cross-sectional schematic diagram of a production device used for producing the GaAs ingot of this disclosure; and
FIG. 4 is a cross-sectional schematic diagram of a crucible 3 used for producing the GaAs ingot of this disclosure and corresponds to a state where the crucible 3 is filled with raw materials, etc. before the start of crystal growth.

DETAILED DESCRIPTION

Prior to the description of embodiments, site names and physical property measurement methods are described for describing this disclosure.

<GaAs ingot>

(Seed side, center portion, and tail side of GaAs ingot)

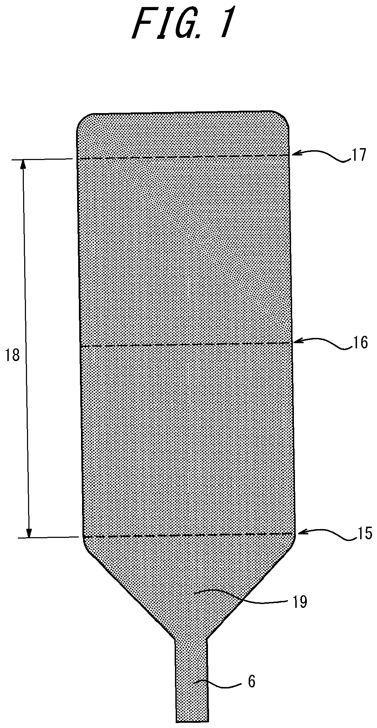

A GaAs wafer and a GaAs wafer group according to this disclosure can be obtained by cutting out a GaAs ingot obtained by a method of producing a GaAs ingot according to this disclosure. FIG. 1 is a schematic diagram of the GaAs ingot obtained according to the production method of this disclosure. The GaAs ingot has a straight body portion 18 having an approximate identical diameter via a region 19 (also referred to as a cone portion) that increases in diameter from a seed crystal 6. When a length from a position 15 at which the cone portion changes to the straight body portion to a position 17 at which the straight body portion ends is 100%, and the former position 15 is set to 0%, while the latter position 17 is set to 100%, the range of 1 to 5% is referred to as a seed side of the straight body portion (hereinafter, simply referred to as a seed side), the range of 40 to 60% is referred to as a center portion of the straight body portion (hereinafter, simply referred to as a center portion), and the range of 80 to 92% is referred to as a tail side of the straight body portion (hereinafter, simply referred to as a tail side). FIG. 1 illustrates a position 16, which is the midpoint (50%) between the position 15 and the position 17. When a length from the position 15 at which the cone portion changes to the straight body portion to the position 17 at which the straight body portion ends is 100%, the percent of the position of each wafer from the seed side of the straight body portion is also referred to as a "position from the straight body seed".

Respective measurement values of the silicon (Si) concentration, the indium (In) concentration, the boron (B) concentration, the carrier concentration, the average dislocation density, the maximum dislocation density, the proportion of the area of a region with zero dislocation density to the wafer surface, and the absorption coefficient at a wavelength of 940 nm of the GaAs wafer and the GaAs wafer group according to this disclosure can be obtained by performing the measurement on a wafer obtained from the straight body portion 18 of the GaAs ingot.

The size of the wafer according to this disclosure is a wafer size determined in the SEMI standard. The size of the wafer can be selected as appropriate from the diameter of the straight body portion 18 of the GaAs ingot. The size of the wafer can be, for example, 2 inches (diameter: 50 mm $\pm$ 0.1 mm) or more and is preferably 3 inches (diameter: 76 mm $\pm$ 0.1 mm) or more. From the point of the appropriateness for surface-emitting laser application, the size of the wafer is preferably 6 inches (diameter: 150 mm $\pm$ 0.1 mm) or more. No specific limitations are placed on the upper limit of the wafer size. The wafer size can be, for example, 8 inches (diameter: 200 mm $\pm$ 0.1 mm) or less.

The evaluation at the seed side, the center portion, and the tail side of the GaAs ingot can be performed on wafers cut out from the respective ranges.

In the measurement, any of upper and lower two surfaces of the wafer can be used.

The following describes methods of measuring respective measurement values of the carrier concentration, the average dislocation density, the maximum dislocation density, the proportion of the area of a region with zero dislocation density to the wafer surface, the absorption coefficient, as well as the Si concentration, the In concentration, and the B concentration.

(Method of measuring carrier concentration)

The carrier concentration is a value measured by the Hall measurement using the Van der Pauw method after breaking out a fraction with a size of 10 mm $\times$ 10 mm at the wafer center portion from the extracted wafer and putting indium electrodes to its four corners to heat the fraction to 330 to 360°C.

(Method of measuring average dislocation density)

The average dislocation density is obtained by the measurement of a etch pit density (EPD). The measurement is performed by, after pretreating the surface of the extracted wafer with a sulfuric acid mirror etchant ($H_2SO_4$:$H_2O_2$:$H_2O$ = 3:1:1 (volume ratio)), immersing the wafer in a KOH melt with a liquid temperature of 320°C for 35 minutes to generate etch pits, and counting the number of the etch pits. The measurement objects are etch pits that have hexagon-like shapes specific to zinc blende type crystals and have a major axis (length of diagonal passing through the center) of 20 $\mu$m or more.

The measurement of the etch pit density is performed by setting 69 or 37 areas with a diameter of 3 mm on the wafer, observing each area with a microscope, and counting the number of the generated etch pits.

The 69 or 37 areas are evenly distributed over the whole wafer surface.

In a case of a 6-inch wafer, 69 areas are set at positions equally dispersed at intervals of 15 mm. In a case of a 3-inch wafer, 37 areas are set at positions equally dispersed at intervals of 10 mm.

When 69 areas are set at equally dispersed positions, the interval of each area is 5 mm in a case of a 2-inch wafer, 10 mm in a case of a 4-inch wafer, and 20 mm in a case of an 8-inch wafer.

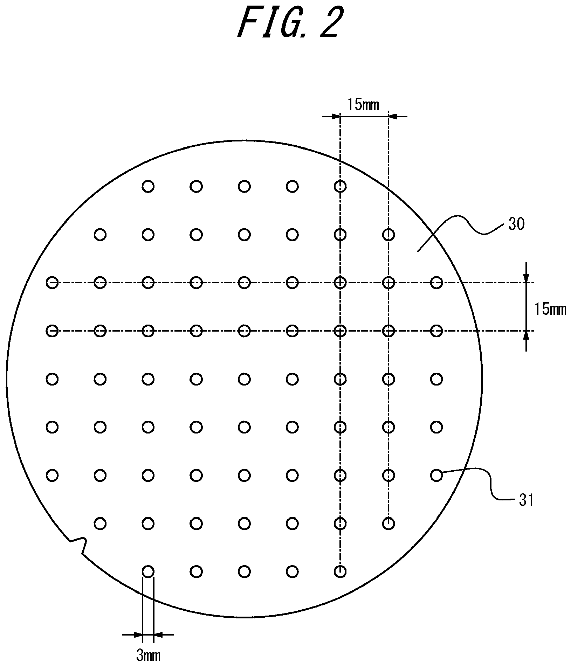

FIG. 2 illustrates a schematic diagram of a 6-inch wafer in which 69 areas are set.

For the observation of each area, a 10x objective lens with a field of view diameter of 1.73 mm is used. For all areas, the field of view in which the greatest number of pits are observed is searched in each area to count the number of the etch pits, and the number of etch pit counts is converted into a value per unit area (cm$^{-2}$). The value obtaining by averaging the converted values of the numbers of etch pit counts in the respective areas is an average dislocation density. The measurement objects are etch pits that have hexagon-like shapes specific to zinc blende type crystals and have a major axis (length of diagonal passing through the center) of 20 $\mu$m or more.

(Method of measuring proportion of area of region with zero dislocation density to wafer surface and maximum dislocation density)

The proportion of the area of a region with zero dislocation density to the wafer surface is determined by generating etch pits in the same way as the above and measuring the distribution of these etch pits.

For the distribution of the etch pits, a region excluding a toric part with a width of 3 mm from the outer periphery toward the center of the wafer surface from the whole wafer surface is divided into areas of 1 mm square, and each area is observed with a microscope using a 10x objective lens to count the number of etch pits in each area. At a position where the outer peripheral line of the region excluding a toric part with a width of 3 mm overlaps the areas of 1 mm squares (the outer peripheral line crosses the 1 mm squares), when the area that falls within the measurement region within the outer peripheral line of a 1 mm square is large, the total area of this 1 mm square is measured, while the area that falls within the measurement region within the outer peripheral line of a 1 mm square is small, the total area of this 1 mm square is not measured, so that the area surrounded by the 1 mm squares with respect to the area surrounded by the outer peripheral line has an error within ± 2% (preferably, an error within ± 1.5%). For example, in the embodiment, the effective number of the areas of 1 mm squares to be measured at the whole wafer surface can be 3881 in the case of a 3-inch wafer (diameter: 76 mm), 6849 in the case of a 4-inch wafer (diameter: 100 mm), and 16529 in the case of a 6-inch wafer (diameter: 150 mm). The number of etch pits in each area may be counted by taking picture of each area using a camera equipped with a 10x objective lens. The proportion of the number of areas where the number of etch pits is 0 to the total number of areas is the proportion of the area of a region with zero dislocation density to the wafer surface.

Moreover, the greatest number of counts of the numbers of etch pit counts in the respective areas is the maximum dislocation density ($mm^{-2}$).

(Method of measuring absorption coefficient)

When the absorption coefficient is measured, both of the back surface and the front surface of the extracted wafer is mirror finished to be a damage free state. At this time, in a case of a wafer sliced using a wire-saw, it is desirable to mirror finish the wafer by polishing both surface with 70 μm or more in total. The absorption coefficient is a value obtained by performing transmittance measurement with a spectrophotometer (UH5700 produced by Hitachi High-Tech Science Corporation) using a sample cut out with a size of 20 mm × 20 mm from around the center of the GaAs wafer that has been mirror finished in such a manner and whose thickness after finishing has been measured. The measurement conditions are as described below:

Baseline setting: Air calibration;
Start wavelength: 1300 nm;
End wavelength: 850 nm;
Sampling interval: 1 nm;
Number of measurements: 1 time;
Scanning speed: 60 nm/min; and
Slit width: 2 nm.

An absorption coefficient $\alpha$ was determined according to the following formulas [1] and [2] using a double-sided reflection model from the transmittance measured using the spectrophotometer. For calculating the refractive index for each wavelength, the document value described in "Refractive Index of GaAs_Journal of Applied Physics 1964" was employed. [Mathematical 1]

$$T = \frac{I}{I_0} = \frac{(1-R)^2 \times exp(-\alpha d)}{1 - R^2 \times exp(-2\alpha d)} \quad \cdots \quad [1]$$

[Mathematical 2]

$$R = \frac{(n-1)^2}{(n+1)^2} \quad \cdots \quad [2]$$

However, $I_0$ is a light intensity before incidence, I is a light intensity after wafer transmission, T is a transmittance, R is a reflectance, $\alpha$ is an absorption coefficient, d is a wafer thickness, and n is a wafer refractive index.

(Method of measuring Si concentration, In concentration, and B concentration)

The Si concentration, the In concentration, and the B concentration are values obtained by etching the surface of the extracted wafer with an etchant ($NH_4OH:H_2O_2:H_2O$ = 1:1:10 (volume ratio)) to a depth of 5 μm, washing the wafer with pure water, drying it, and then analyzing it by Secondary Ion Mass Spectrometry (SIMS).

Specifically, for Si and B, the wafer is measured to a depth of 0.5 to 1 μm from the surface by setting the ion energy to 14.5 keV by the SIMS analysis with cesium ions. For In, the wafer is measured to a depth of 3 μm from the

surface by setting the ion energy to 5.5 keV by the SIMS analysis with oxygen ions.

<Method of producing GaAs ingot>

The following describes a method of producing a GaAs ingot according to this disclosure. In this production method, by the vertical gradient freezing (VGF) method or the vertical Bridgman (VB) method, using silicon (Si) and indium (In) as dopants, and using boric oxide ($B_2O_3$) as a sealant, boric oxide ($B_2O_3$) is stirred to lower the silicon concentration at the center portion of the GaAs ingot than the silicon concentration at the seed side to cause crystal growth.

In the method of producing a GaAs ingot according to this disclosure, In is further added as a dopant in addition to Si to achieve low dislocation density of the GaAs ingot to be obtained.

In the production of the GaAs ingot by the vertical gradient freezing (VGF) method or the vertical Bridgman (VB) method, the crystal growth advances such that the solid-liquid interface moves from the edge at the seed crystal side toward the edge at the opposite side. After the crystal growth passes through the cone portion, in general, the condensation of Si into a GaAs melt occurs by segregation (segregation coefficient of Si into GaAs (0.14)) to increase the Si concentration toward the tail side. Suppressing the increase in Si concentration associated with the crystal growth to lower the Si concentration at the center portion of the GaAs ingot than the Si concentration at the seed side is advantageous to increase the proportion of the area of a region with zero dislocation density. In the method of producing a GaAs ingot according to this disclosure, the Si concentration is controlled as describe below.

In the production of the GaAs ingot, Si is dissolved in the GaAs melt, and the following reaction occurs at the interface with $B_2O_3$.

$$3 \text{ Si (in melt)} + 2B_2O_3 \longleftrightarrow 3SiO_2 \text{ (into } B_2O_3\text{)} + 4B \text{ (in melt)}$$

In the method of producing a GaAs ingot according to this disclosure, by stirring $B_2O_3$ during the crystal growth, $B_2O_3$ with a small content of Si is supplied to the interface with the melt to facilitate the reaction between $B_2O_3$ and Si in the melt, which advances the above reaction to the right side to suppress the increase in Si concentration. At this time, the stirring is performed so that the Si concentration at the center portion of the GaAs ingot is lower than the Si concentration at the seed side. In a state where In is used as a dopant and In exists in the GaAs melt, the crystal growth is performed from the seed to the cone portion in a state where a large amount of Si has been preliminarily contained in the melt, and from the crystal growth of the straight body portion, Si in the melt is incorporated into $B_2O_3$ efficiently in large amounts to prevent the Si concentration from increasing due to the segregation of Si. In this manner, it is possible to obtain a wafer with suppressed carrier concentration and low dislocation density, as well as a large proportion of the area of a region with zero dislocation density to the GaAs wafer surface. By incorporating a large amount of Si in the melt into $B_2O_3$, a large amount of B is supplied into the melt.

In this manner, it is possible to produce a GaAs ingot that can obtain more wafers with large proportion of the area of a region with zero dislocation density, and low carrier concentration, in cooperation with the effect by the addition of In as a dopant.

Moreover, in the method of producing a GaAs ingot according to this disclosure, the activation rate of silicon added as a dopant can be reduced, which can control the carrier concentration and thus the absorption coefficient.

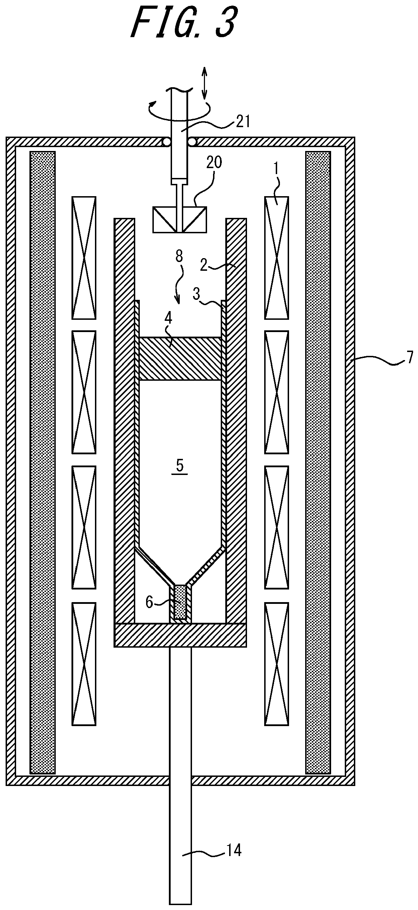

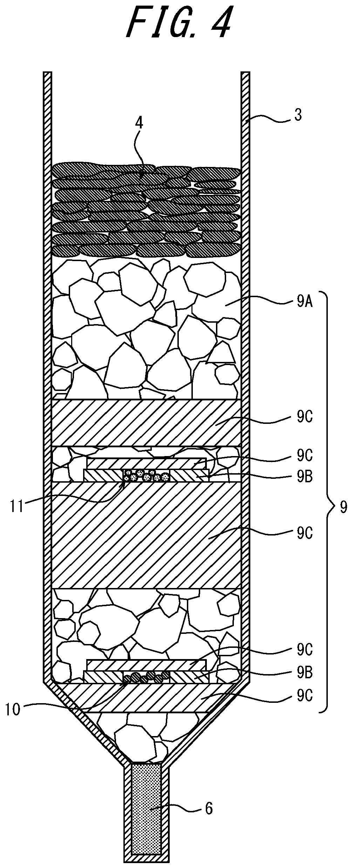

The following describes the production method in more detail with reference to FIG. 3 and FIG. 4.

(Production device and temperature control)

FIG. 3 schematically illustrates a cross-sectional view of an example of a production device used in the method of producing a GaAs ingot according to this disclosure.

The production device illustrated in FIG. 3 includes an air tight container 7 that can be evacuated and filled with atmosphere gas from the outside, a crucible 3 arranged at the center in the air tight container 7, a crucible housing container (susceptor) 2 that houses and holds the crucible 3, a mechanism 14 that moves up and down and/or rotates the crucible housing container (susceptor) 2 (only an up-and-down and rotating rod is illustrated), and a heater 1 mounted to surround the crucible housing container (susceptor) 2 in the air tight container 7.

Above the crucible 3, an upper rod 21, to which a stirring blade 20 that can rotate and move up and down is attached, is arranged. The stirring blade 20 and the upper rod 21 form a stirring means. The stirring blade 20 can be removed from the upper rod 21. A sealant housing container and other members can be attached to the upper rod 21.

The crucible 3 can be formed of pyrolytic boron nitride (PBN). In FIG. 3, the crucible 3 is filled with the seed crystal 6, compound semiconductor raw materials 5, and a sealant ($B_2O_3$) 4, and the air tight container 7 is filled with an inert gas 8 as an example.

FIG. 4 schematically illustrates a cross-sectional view of an example of a crucible used in the method of producing a GaAs ingot according to this disclosure and corresponds to a state where the crucible is filled with raw materials, etc. before the start of crystal growth. The crucible 3 illustrated in FIG. 4 is filled with the seed crystal 6, GaAs polycrystalline raw materials 9, a dopant (silicon) 10, a dopant (indium) 11, and a sealant ($B_2O_3$) 4. In FIG. 4, the GaAs polycrystalline raw materials 9 are arranged as crushed GaAs polycrystals (9A), cylindrical GaAs polycrystal containers (9B), and disk GaAs polycrystals (9C). However, the GaAs polycrystalline raw materials 9 are not limited to such an aspect. For example, only crushed GaAs polycrystals may be arranged.

After the end of the filling, in a growing furnace filled with the inert gas, the temperature of the GaAs polycrystalline raw materials 9 is increased to the melting point of GaAs, 1238°C, or more, while applying a temperature gradient by a PID controlled heater to decrease the temperature at the side of the seed crystal 6, to prevent the seed crystal 6 from melting. Then, the GaAs polycrystalline raw materials 9 and the sealant ($B_2O_3$) 4 are melted to dissolve the dopant (silicon) and the dopant (indium) 11 in the GaAs melt. Subsequently, when the temperature around the seed crystal 6 is increased and the upper portion of the seed crystal 6 is melted, the entire temperature is gradually decreased while applying the temperature gradient, which can obtain a GaAs ingot. At this time, the rate of temperature decrease is preferably 10°C/h or less.

(Stirring)

In the method of producing GaAs according to this disclosure, the sealant ($B_2O_3$) 4 is stirred during the crystal growth. At this time, the stirring is performed so that the Si concentration at the center portion of the GaAs ingot is lower than the Si concentration at the seed side. It is preferable to start the stirring between the time point at which the crystal growth starts at the seed side of the straight body portion and the time point at which the crystal growth reaches the center portion (position from the straight body seed: 1 to 40%). It is more preferable to start the stirring at the time point with a position from the straight body seed of 1 to 20%. The stirring may be started prior to this time point. For example, the stirring may be started in the middle of the cone portion or at the time point at which the crystal growth starts at a part where the cone portion is switched to the straight body portion (position from the straight body seed: around 0%). The stirring preferably continues until the crystal growth at the tail side of the straight body portion ends and may be continue until the crystal growth ends.

The stirring is preferably performed by arranging and rotating the stirring means in the sealant ($B_2O_3$) 4. The number of rotations is preferably adjusted by gradually increasing it from a small number so as to moderately adjust the change in Si concentration. The number of rotations may be changed stepwise or changed continuously. The maximum number of rotations to reach is preferably 6 rpm or more, and more preferably 10 rpm or more, from the point of reaction promotion. The number of rotations can be, for example, 20 rpm or less.

The stirring means may have a form where the stirring blade is attached to around the rotation shaft.

No specific limitations are placed on the shape of the stirring blade. The stirring blade can be formed of a plate member with a predetermined shape and is, for example, formed of two to eight approximately quadrangular plate members. As its material, carbon, BN, etc. are used. The plate member is preferably attached with an angle of gradient of 45° or more and 135° or less with respect to the interface formed by the GaAs melt and $B_2O_3$ in a resting state.

For the stirring blade, the area formed by the rotation locus when the stirring means is rotated is preferably 30% or more, and more preferably 70% or more of the area of the interface formed by the GaAs melt and $B_2O_3$ in the resting state.

The distance between the lower end of the stirring blade and the interface formed by the GaAs melt and $B_2O_3$ in the resting state is preferably less than 2 mm, and preferably 1 mm or less. However, it is preferable to prevent the lower end of the stirring blade from contacting the interface.

(Seed crystal)

No specific limitations are placed on the size of the seed crystal 6. However, the seed crystal 6 may have a cross-sectional area of, for example, 1 to 20% and preferably have a cross-sectional area of 3 to 17% with respect to the cross-sectional area having a diameter that is the inner diameter of the crucible 3. When the diameter of the crystal to be grown exceeds 100 mm, the cross-sectional area of the seed crystal 6 can be 2 to 10% with respect to the cross-sectional area having a diameter that is the crucible inner diameter.

(Crucible inner diameter and wafer size)

The inner diameter of the crucible 3 is preferably slightly larger than the aimed wafer size. The aimed wafer size can be, for example, 2 inches or more and is preferably 3 inches or more, and further preferably 6 inches or more. No specific limitations are placed on the upper limit of the wafer size. The upper limit of the wafer size can be, for example, 8 inches or less.

(Dopant)

Silicon (Si) and indium (In) are used as dopants. The dopant (silicon) 10 is added to the GaAs polycrystalline raw materials 9, with a weight to achieve a desired concentration by the shot of high purity Si or by crushing a high purity Si substrate. The dopant (indium) 11 is also added to the GaAs polycrystalline raw materials 9, with a weight to achieve a desired concentration using high purity In, indium compound (e.g., high purity indium arsenide (InAs)).

It is advantageous to have high Si concentration and good crystallizability at a region from around the seed crystal to the cone portion, which is an early stage of the crystal growth, for low dislocation density. Thus, the silicon charge amount is preferably equal to or more than the amount used for producing a normal silicon doped GaAs ingot.

The silicon charge amount can be, for example, 110 wtppm or more and 150 wtppm or less and is preferably 120 wtppm or more and 140 wtppm or less, and more preferably 130 wtppm or more and 140 wtppm or less, with respect to GaAs polycrystalline raw materials. The silicon charge amount does not include the amount of silicon contained in $B_2O_3$.

The silicon charge amount can be an amount to have a silicon concentration at the seed side of the straight body portion of $7.0 \times 10^{17}$ cm$^{-3}$ or more, when a GaAs ingot is produced under the same conditions except that $B_2O_3$ is not stirred. In particular, with a large diameter of 4 inches or more such as 6 inches, by setting the silicon concentration at the seed side of the straight body portion to $7.0 \times 10^{17}$ cm$^{-3}$ or more, at least a wafer at the center portion of the straight body portion has low dislocation density, and it is possible to obtain a wafer with a large proportion of the area of a region with zero dislocation density to the GaAs wafer surface. However, if indium to be described below is not charged, even though the silicon concentration at the seed side of the straight body portion is set to $7.0 \times 10^{17}$ cm$^{-3}$ or more, the proportion of the area of a region with zero dislocation density is small and is not 91.0% or more.

The indium charge amount can be 100 wtppm or more and 5000 wtppm or less and is preferably 500 wtppm or more and 4000 wtppm or less, and more preferably 1000 wtppm or more and 2000 wtppm or less, with respect to the GaAs polycrystalline raw materials. When high purity indium arsenide (InAs) is added to add In, the indium charge amount may be converted from the charge amount of InAs raw materials. The melting point of In is 156°C, and the melting point of InAs is 942°C. Thus, these melting points are significantly lower than the melting point of GaAs, 1238°C. When, previously melted In adheres to around the seed crystal 6 before the start of GaAs crystal growth, single crystallization is inhibited. Thus, any measures are necessary to prevent the previously melted In from easily adhering to around the seed crystal 6, such as putting the dopant (indium) 11 into a position away from the seed crystal 6 or devising the arrangement of the GaAs polycrystalline raw materials 9.

As the above measures, one or more of the following measures are preferably used. FIG. 4 illustrates an example of the aspect.

The dopant (indium) 11 is arranged above the center of the crucible (position corresponding to the center portion of the ingot).

The dopant (indium) 11 is put into a container (GaAs container) produced from GaAs crystal or GaAs polycrystal, so that the dopant inside does not come out of the container until the temperature at which the GaAs container melts.

The dopant (silicon) 10 is preferably arranged below the center of the crucible (position corresponding to the center portion of the ingot) (seed crystal side). The dopant (silicon) 10 may be put into the GaAs container, so that the dopant inside does not come out of the container until the temperature at which the GaAs container melts. Silicon has a density lower than that of GaAs. Thus, the dopant (silicon) floats upward in the melt, and the silicon concentration in the GaAs melt at the seed crystal side decreases, which may decrease the silicon concentration at the seed side of the GaAs ingot. However, the use of the GaAs container is effective to avoid such matters.

The size of the seed crystal 6 is preferably within the above range also for preventing In from easily adhering to around the seed crystal 6.

Elements conceivable as dopants other than silicon and indium include beryllium (Be), magnesium (Mg), aluminum (Al), carbon (C), germanium (Ge), tin (Sn), nitrogen (N), sulfur (S), selenium (Se), and tellurium (Te) and further include zinc (Zn), cadmium (Cd), chromium (Cr), and antimony (Sb). However, these elements are allowable in inevitably mixed amounts, but it is preferable that these elements are not intentionally added.

(Sealant ($B_2O_3$))

As the sealant ($B_2O_3$) 4, for the reaction promotion with silicon, a sealant ($B_2O_3$) with reduced content of silicon is preferably used. For example, the silicon concentration in $B_2O_3$ can be 2 mol% or less, is preferably 1 mol% or less, and may be 0 mol%. A smaller silicon concentration in $B_2O_3$ tends to decrease the activation rate. Moreover, by setting the silicon concentration in $B_2O_3$ to 1 mol% or less, it is possible to obtain more wafers with a large proportion of the area of a region with zero dislocation density to the GaAs wafer surface, from the ingot.

Silicon may be contained in $B_2O_3$ in a form of Si oxide.

In addition to the above, conventionally well-known methods may be added to adjust the concentrations with which Si, In, and B are incorporated into the GaAs ingot during the crystal growth, and the carrier concentration, the average dislocation density, and the absorption coefficient.

According to the method of producing a GaAs ingot according to this disclosure, at at least any position of the seed side, the center portion, and the tail side of the GaAs ingot, it is possible to have a part having a silicon concentration of $1.0 \times 10^{17}$ cm$^{-3}$ or more and less than $1.1 \times 10^{18}$ cm$^{-3}$, an indium concentration of $3.0 \times 10^{18}$ cm$^{-3}$ or more and less than $3.0 \times 10^{19}$ cm$^{-3}$, and a boron concentration of $2.5 \times 10^{18}$ cm$^{-3}$ or more, having a carrier concentration of $1.0 \times 10^{16}$ cm$^{-3}$ or more and $4.0 \times 10^{17}$ cm$^{-3}$ or less, and having a region with zero dislocation density to the wafer surface of 91.0% or more.

It is preferable that at least the center portion of the straight body portion has such a part. It is more preferable that all of the seed side, the center portion, and the tail side of the straight body portion each have such a part.

In addition, this part can have an average dislocation density of 250 cm$^{-2}$ or less and can have an absorption coefficient at a wavelength of 940 nm of 3.5 cm$^{-1}$ or more and 7.0 cm$^{-1}$ or less.

<GaAs wafer>

The GaAs wafer according to this disclosure can be obtained by cutting out a wafer from at least any position of the seed side, the center portion, and the tail side of the GaAs ingot obtained by the method of producing a GaAs ingot according to this disclosure. The GaAs wafer according to this disclosure can be preferably obtained from the center portion and can be further preferably obtained from all of the seed side, the center portion, and the tail side.

The GaAs wafer according to this disclosure has a silicon concentration of $1.0 \times 10^{17}$ cm$^{-3}$ or more and less than $1.1 \times 10^{18}$ cm$^{-3}$, an indium concentration of $3.0 \times 10^{18}$ cm$^{-3}$ or more and less than $3.0 \times 10^{19}$ cm$^{-3}$, and a boron concentration of $2.5 \times 10^{18}$ cm$^{-3}$ or more, has a carrier concentration of $1.0 \times 10^{16}$ cm$^{-3}$ or more and $4.0 \times 10^{17}$ cm$^{-3}$ or less, and has a region with zero dislocation density to the wafer surface of 91.0% or more. This GaAs wafer can have an average dislocation density of 250 cm$^{-2}$ or less and can have an absorption coefficient at a wavelength of 940 nm of 3.5 cm$^{-1}$ or more and 7.0 cm$^{-1}$ or less.

The following describes the ranges of the Si concentration, the In concentration, the B concentration, the average dislocation density, the maximum dislocation density, the proportion of the area of a region with zero dislocation density to the wafer surface, the carrier concentration, the absorption coefficient, etc. of the GaAs wafer according to this disclosure.

(Range of Si concentration)

From the viewpoint that an excessive Si concentration causes free carrier absorption and the viewpoint of controlling the carrier concentration, the Si concentration of the GaAs wafer according to this disclosure is $1.0 \times 10^{17}$ cm$^{-3}$ or more and less than $1.1 \times 10^{18}$ cm$^{-3}$.

(Range of In concentration)

From the point of ensuring the effect of decrease in dislocation density by the addition of In, while preventing displacement of lattice constants or bandgap of GaAs crystal from occurring due to the excessive In concentration, the In concentration of the GaAs wafer according to this disclosure is $3.0 \times 10^{18}$ cm$^{-3}$ or more and less than $3.0 \times 10^{19}$ cm$^{-3}$.

(Range of B concentration)

The GaAs wafer according to this disclosure can be advantageously obtained by the reaction promotion between the sealant ($B_2O_3$) and Si as a dopant, in the crystal growth of the GaAs ingot by the VGF method or the VB method. Thus, the B concentration is $2.5 \times 10^{18}$ cm$^{-3}$ or more, and the B concentration is preferably $3.0 \times 10^{18}$ cm$^{-3}$ or more. No specific limitations are placed on the upper limit of the B concentration. However, the B concentration can be $3.0 \times 10^{19}$ cm$^{-3}$ or less.

(Elements other than the above and concentrations thereof)

It is preferable that elements other than Si and In are not added, other than GaAs, except for B and oxygen (O) mixed in the GaAs ingot by $B_2O_3$ used as the sealant. Only Si and In are added as dopants, and it is preferable that the other elements are not intentionally added as dopants.

Elements conceivable as dopants other than silicon and indium include beryllium (Be), magnesium (Mg), aluminum (Al), carbon (C), germanium (Ge), tin (Sn), nitrogen (N), sulfur (S), selenium (Se), and tellurium (Te) and further include zinc (Zn), cadmium (Cd), chromium (Cr), and antimony (Sb). However, these elements are allowable in inevitably mixed amounts, but it is preferable that these elements are not intentionally added.

For example, each concentration of Al, C, and Zn in GaAs by the SIMS analysis is preferably $3 \times 10^{16}$ cm$^{-3}$ or less (including zero). Each concentration of Be, Mg, Ge, Sn, N, S, Se, Te, Cd, Cr, and Sb other than these elements is preferably $5 \times 10^{15}$ cm$^{-3}$ or less (including zero). Furthermore, the concentration of N is more preferably $1 \times 10^{15}$ cm$^{-3}$ or less.

(Range of average dislocation density)

The value of the average dislocation density of the GaAs wafer according to this disclosure is preferably 250 cm$^{-2}$ or less. No specific limitations are placed on the lower limit of the average dislocation density. When the average dislocation density is 10 cm$^{-2}$ or more, in particular, 30 cm$^{-2}$ or more, the effect of specifying the proportion of the area a region with zero dislocation density is effectively provided.

(Proportion of area of region with zero dislocation density to wafer surface)

The GaAs wafer according to this disclosure has a proportion of the area of a region with zero dislocation density to the wafer surface of 91.0% or more. Thus, when the GaAs wafer is used for a surface-emitting laser such as a semiconductor laser, good characteristics in applications thereof can be achieved. The proportion of the area of a region with zero dislocation density to the wafer surface may be 100%.

(Range of carrier concentration)

The GaAs wafer according to this disclosure has a carrier concentration of $1.0 \times 10^{16}$ cm$^{-3}$ or more and $4.0 \times 10^{17}$ cm$^{-3}$ or less.

(Range of absorption coefficient)

The absorption coefficient at a wavelength of 940 nm is preferably 3. 5 cm$^{-1}$ or more and 7.0 cm$^{-1}$ or less.

<GaAs wafer group>

The GaAs wafer group according to this disclosure can be obtained by cutting out a plurality of wafers from at least any position of the seed side, the center portion, and the tail side of the GaAs ingot obtained by the method of producing a GaAs ingot according to this disclosure. The GaAs wafer group according to this disclosure can be preferably obtained from the center portion and can be further preferably obtained from all of the seed side, the center portion, and the tail side.

The GaAs wafer group according to this disclosure is consist of a plurality of wafers obtained from an identical ingot. No specific limitations are placed on the number of the plurality of wafers so long as the number is 2 or more. However, the plurality of wafers are preferably half or more of the total number of wafers that can be cut out from an identical ingot, more preferably the total number of wafers obtained from the center portion of an identical ingot, and further preferably the total number of wafers obtained from the seed side to the tail side of an identical ingot. The plurality of wafers are particularly preferably the total number of wafers obtained between the edge at the seed crystal side of the seed side and the edge opposite to the seed crystal of the tail side.

Each of the plurality of wafers has a silicon concentration of $1.0 \times 10^{17}$ cm$^{-3}$ or more and less than $1.1 \times 10^{18}$ cm$^{-3}$, an indium concentration of $3.0 \times 10^{18}$ cm$^{-3}$ or more and less than $3.0 \times 10^{19}$ cm$^{-3}$, and a boron concentration of $2.5 \times 10^{18}$ cm$^{-3}$ or more, has a carrier concentration of $1.0 \times 10^{16}$ cm$^{-3}$ or more and $4.0 \times 10^{17}$ cm$^{-3}$ or less, and has a region with zero dislocation density to the wafer surface of 91.0% or more. This GaAs wafer can have an average dislocation density of 250 cm$^{-2}$ or less and can have an absorption coefficient at a wavelength of 940 nm of 3.5 cm$^{-1}$ or more and 7.0 cm$^{-1}$ or less. These preferred ranges are as described for the GaAs wafer according to this disclosure.

It is preferable that the plurality of wafers include a wafer obtained from the center portion of the straight body portion of the GaAs ingot and that the wafer obtained from the center portion further has a carrier concentration of less than $2.0 \times 10^{17}$ cm$^{-3}$. The carrier concentration of the wafer obtained from the center portion can be $1.0 \times 10^{16}$ cm$^{-3}$ or more.

The GaAs wafer according to this disclosure has suppressed carrier concentration and low dislocation density, as well as a large proportion of the area of a region with zero dislocation density to the GaAs wafer surface, and thus is suitable for the substrate of the surface-emitting laser including a vertical cavity surface-emitting laser (VCSEL).

The above describes the examples of representative embodiments of this disclosure, and this disclosure is not limited to these examples. The following describes this disclosure in more detail using examples. However, this disclosure is not limited to the following examples.

EXAMPLES

(Crystal number 1)

A GaAs ingot was produced using a production device having a configuration illustrated in FIG. 3. The stirring blade is formed by attaching four quadrangular plate members with a material having no effect on the crystal characteristics, such as carbon and BN, to the rod. The area formed by the rotation locus when the stirring blade rotates is 50% or more of the area of the interface formed by the GaAs melt and $B_2O_3$ in the resting state.

<Filling of crucible with raw materials>

The crucible 3 formed of PBN with an inner diameter of 159.9 mm and the inner diameter of the seed portion of 6.0 to 6.5 mm was prepared as a crucible. The crucible was filled with the GaAs polycrystalline raw materials 9A of 20,000 ± 10 g, which were obtained by crushing GaAs polycrystal formed by synthesizing Ga of 6N (purity: 99.9999% or more) and As of 6N, and the GaAs seed crystal 6, which was cut out such that a (100) surface is a crystal growth surface, as illustrated in FIG. 4. The diameter of the GaAs seed crystal 6 was adjusted by a combination of machine grinding and etching so that it is smaller than the inner diameter of the seed portion of each crucible by about 0.5 mm. In the middle of filling the crucible with the GaAs polycrystal, the crucible was filled with high purity Si shot of 100 wtppm as the dopant (silicon) 10 and high purity InAs shot of 2000 wtppm (In equivalent: 1210 wtppm) as the dopant (indium) 11, with respect to the GaAs polycrystalline raw materials. No impurity elements were intentionally added other than Si and In. The crucible was filled with the granular dopant (silicon) 10 and dopant (indium) 11, which were each in a state contained in a GaAs container formed by sandwiching a cylindrical GaAs polycrystal 9B between disk GaAs polycrystals 9C from up and down, so that the dopant inside does not come out of the GaAs container until the temperature at which the GaAs container melts. The dopant (indium) 11 was arranged above the center of the crucible 3, while the dopant (silicon) 10 was arranged near the seed crystal 6 under the center of the crucible 3.

<Crystal growth>

After the crucible was filled with these raw materials, the crucible was filled with the sealant, $B_2O_3$ (Si concentration: 5 mol%) 4 of 965 ± 10g. The crucible 3 after the filling was set in the crucible housing container (susceptor). After the inside of the production device illustrated in FIG. 3 was repeatedly evacuated and substituted by Ar gas to make an inert gas atmosphere, single crystal was grown by the VGF method.

In the crystal growth step, first, the temperature of the raw materials in the crucible was increased to the melting point of GaAs, 1238°C, or more to prepare a melt, while applying a temperature gradient by a PID controlled heater to decrease the temperature at the seed crystal side, to prevent the GaAs seed crystal from melting. Then, after increasing the temperature around the seed crystal to melt the upper portion of the seed crystal, the temperature of the entire furnace was decreased at a rate of 10°C/h or less by heater control while applying the temperature gradient, which grew an n-type GaAs ingot with Si as a dopant.

After the ingot grew to the place where the cone portion underwent the crystal growth to reach the crystal straight body portion, the stirring blade was rotated to start the stirring of $B_2O_3$, such that the distance between the interface between the sealant, $B_2O_3$, and the crystal tail side, and the lower end of the stirring blade was 3 mm or less and the lower end did not contact the interface. The rotation rate of the stirring blade is increase stepwise from a small number of rotations to 10 rpm, and the stirring was continued at 10 rpm by the completion of growth of the tail side. The number of rotations of the stirring blade was adjusted as the number of rotations increases stepwise, so that the number of rotations is 5 rpm from the position of 25 mm from the place where the cone portion underwent the crystal growth to reach the crystal straight body portion to the straight body portion side (position from the straight body seed: 16%) to the position of 50 mm, 7.6 rpm from the position of 50 mm (position from the straight body seed: 30%) to the position of 100 mm, and 10 rpm after the position of 100 mm (position from the straight body seed: 61%).

<Evaluation>

The straight body portion of the grown GaAs ingot was sliced with a wire-saw to form a wafer. The wafer size corresponds to 6 inches. The last cutting surface was at a position of 20 mm from the edge at the side opposite to the seed crystal side of the ingot (in the seed side direction).

The evaluation was performed on each wafer obtained at the seed side, the center portion, and the tail side of the straight body portion of the GaAs ingot, and each wafer obtained between the seed side and the center portion and between the center portion and the tail side.

In the measurement, which is described below, at least three wafers were used for each position. The cutting out position from the ingot of one of these wafers is as presented in Table 1. When a length from the position at which the cone portion of the ingot changes to the straight body portion to the last cutting surface, which is the position at which the straight body portion ends, is 100%, the former position is 0%, and the latter position is 100%.

From a region (wafer center portion) including the center of the crystal of the sliced wafer (or offcut part), using cleavage of the (110) surface, a fraction with a size of 10 mm × 10 mm was broken out, and the carrier concentration was measured by the Hall measurement using the Van der Pauw method as described above.

After the pretreatment was performed as describe above using the remnant of the wafer used for the Hall measurement, the Si concentration, the In concentration, and the B concentration were measured by the SIMS analysis using a device produced by CAMECA.

The number of etch pits was counted as described above on the surface of the wafer adjacent to (opposite to via an identical cutting surface) the above wafer used for the Hall measurement, and the number of counts was evaluated as an average dislocation density ($cm^{-2}$).

When the number of etch pits was 1000 $cm^{-2}$ or more, the counting was performed by changing the 10x objective lens to a 5x objective lens with a field of view diameter of 3.46 mm.

The proportion of the area of a region with zero dislocation density to the wafer surface, and the maximum dislocation density were determined as described above, using a wafer near the wafer used for the Hall measurement or the EPD measurement.

The absorption coefficient at a wavelength of 920 nm was measured, using a wafer near the wafer used for the Hall measurement or the EPD measurement. When the absorption coefficient was measured, the transmittance was measured using a spectrophotometer (UH5700 produced by Hitachi High-Tech Science Corporation), and the absorption coefficient was determined further using the aforementioned formulas [1] and [2].

(Crystal numbers 2 to 6 and Crystal number 0)

Each GaAs ingot of Crystal numbers 2 to 6 and Crystal number 0 was produced and evaluated in the same manner as in Crystal number 1, except that the condition was changed to the condition presented in Table 1.

(Crystal number 7)

An GaAs ingot was grown in the same manner as in Crystal number 1, using a production device for 3-inch wafer. High purity Si shot of 130 wtppm as a dopant (silicon) and high purity InAs shot of 2000 wtppm (In equivalent: 1210 wtppm) were used with respect to the GaAs polycrystalline raw materials. A wafer was obtained and evaluated in the same manner as in Crystal number 1, except that the straight body portion of the grown GaAs ingot was slice with a wire-saw to form a wafer corresponding to 3 inches.

(Crystal number 8)

A GaAs ingot of Crystal number 8 was produced in the same manner as in Crystal number 6, except that the number of rotations of the stirring blade was adjusted as the number of rotations increases stepwise, so that the number of rotations is 5 rpm from the position of 12.5 mm from the place where the cone portion underwent the crystal growth to reach the crystal straight body portion to the straight body portion side (position from the straight body seed: 8%) to the position of 50 mm, 7.6 rpm from the position of 50 mm to the position of 100 mm, and 10 rpm after the position of 100 mm. Then, a wafer was obtained and evaluated.

(Crystal number 9)

A GaAs ingot of Crystal number 9 was produced and evaluated in the same manner as in Crystal number 8, except that the Si charge amount was changed from 140 wtppm to 130 wtppm, and the Si concentration in $B_2O_3$ was changed from 0 mol% to 0.25 mol%, as in the condition presented in Table 1.

[Table 1]

Table 1

| Production condition | | | | | | Evaluation result | | | | | | | | | | | | |
|---|---|---|---|---|---|---|---|---|---|---|---|---|---|---|---|---|---|---|
| Crystal number | Si charge amount wtppm | $B_2O_3$ Si concentration | Stirring | InAs charge amount wtppm | In charge amount wtppm | Sample number | Position from straight body seed | Position | Si concentration $cm^{-3}$ | In concentration $cm^{-3}$ | B concentration $cm^{-3}$ | Carrier concentration $cm^{-3}$ | Activation rate carrier/Si | Average dislocation density $cm^{-2}$ | Maximum dislocation density $mm^{-2}$ | Proportion of area of region with zero dislocation density % | Absorption coefficient $cm^{-1}$ |
| 0 | 100 | 7 mol% | without | none | none | 0-1 | 1% | Seed side | $8.13\times10^{17}$ | 0 | $5.12\times10^{18}$ | $3.90\times10^{17}$ | 48% | 617 | 50 | 31.4% | - |
| | | | | | | 0-2 | 38% | between seed side and center portion | $1.14\times10^{18}$ | 0 | $6.16\times10^{18}$ | $5.47\times10^{17}$ | 48% | 349 | 74 | 40.8% | - |
| | | | | | | 0-3 | 76% | between center portion and tail side | $2.54\times10^{18}$ | 0 | $1.06\times10^{19}$ | $1.22\times10^{18}$ | 48% | 145 | - | - | - |
| 1 | 100 | 5 mol% | with | 2,000 | 1,210 | 1-1 | 1% | Seed side | $5.87\times10^{17}$ | $3.91\times10^{18}$ | $4.41\times10^{18}$ | $2.76\times10^{17}$ | 47% | 341 | 38 | 75.0% | 4.74 |
| | | | | | | 1-2 | 47% | Center portion | $9.23\times10^{17}$ | $6.08\times10^{18}$ | $5.48\times10^{18}$ | $4.34\times10^{17}$ | 47% | 500 | 145 | 85.0% | 5.35 |
| | | | | | | 1-3 | 92% | Tail side | $1.73\times10^{18}$ | $1.50\times10^{19}$ | $8.03\times10^{18}$ | $8.12\times10^{17}$ | 47% | 251 | 60 | 79.0% | 6.11 |

| | Production condition | | | | | Evaluation result | | | | | | | | | | | |
|---|---|---|---|---|---|---|---|---|---|---|---|---|---|---|---|---|---|
| Crystal number | Si charge amount wtppm | $B_2O_3$ Si concentration | Stirring | InAs charge amount wtppm | In charge amount wtppm | Sample number | Position from straight body seed | Position | Si concentration $cm^{-3}$ | In concentration $cm^{-3}$ | B concentration $cm^{-3}$ | Carrier concentration $cm^{-3}$ | Activation rate carrier/Si | Average dislocation density $cm^{-2}$ | Maximum dislocation density $mm^{-2}$ | Proportion of area of region with zero dislocation density % | Absorption coefficient $cm^{-1}$ |
| 2 | 100 | 2 mol % | with | 2000 | 1,210 | 2-1 | 1% | Seed side | $7.10\times10^{17}$ | $3.70\times10^{18}$ | $4.70\times10^{18}$ | $2.35\times10^{17}$ | 33% | 307 | 45 | 72.7% | 4.57 |
| | | | | | | 22 | 41% | Center portion | $6.89\times10^{17}$ | $5.69\times10^{18}$ | $4.73\times10^{18}$ | $2.76\times10^{17}$ | 40% | 135 | 73 | 93.3% | - |
| | | | | | | 2-3 | 81% | Tail side | $1.00\times10^{18}$ | $1.30\times10^{19}$ | $1.20\times10^{19}$ | $2.80\times10^{17}$ | 28% | 165 | 58 | 84.5% | - |
| 3 | 120 | 2 mol% | with | 2,000 | 1,210 | 3-1 | 1% | Seed side | $8.70\times10^{17}$ | $3.75\times10^{18}$ | $5.00\times10^{18}$ | $3.09\times10^{17}$ | 36% | 259 | 45 | 66.0% | 4.86 |
| | | | | | | 3-2 | 36% | between seed side and center portion | $9.43\times10^{17}$ | $5.34\times10^{18}$ | $5.54\times10^{18}$ | $3.77\times10^{17}$ | 40% | 104 | 48 | 91.0% | 5.47 |
| | | | | | | 3-3 | 56% | Center portion | $4.12\times10^{17}$ | $6.92\times10^{18}$ | $3.85\times10^{18}$ | $1.65\times10^{17}$ | 40% | 16 | 10 | 99.0% | - |
| | | | | | | 3-4 | 86% | Tail side | $9.80\times10^{17}$ | $1.14\times10^{19}$ | $1.10\times10^{19}$ | $3.31\times10^{17}$ | 34% | 75 | 51 | 96.3% | - |

EP 4 411 031 A1

15

| Production condition | | | | | | Evaluation result | | | | | | | | | | | |
|---|---|---|---|---|---|---|---|---|---|---|---|---|---|---|---|---|---|
| Crystal number | Si charge amount wtppm | $B_2O_3$ Si concentration | Stirring | InAs charge amount wtppm | In charge amount wtppm | Sample number | Position from straight body seed | Position | Si concentration $cm^{-3}$ | In concentration $cm^{-3}$ | B concentration $cm^{-3}$ | Carrier concentration $cm^{-3}$ | Activation rate carrier/Si | Average dislocation density $cm^{-2}$ | Maximum dislocation density $mm^{-2}$ | Proportion of area of region with zero dislocation density % | Absorption coefficient $cm^{-1}$ |
| 4 | 130 | 1 mol% | with | 2000 | 1,210 | 4-1 | 1% | Seed side | $7.13\times10^{17}$ | $3.87\times10^{18}$ | $4.81\times10^{18}$ | $228\times10^{17}$ | 32% | 135 | 24 | 94.5% | 5.48 |
| | | | | | | 4-2 | 30% | between seed side and center portion | $4.14\times10^{17}$ | $4.97\times10^{18}$ | $3.86\times10^{18}$ | $1.33\times10^{17}$ | 32% | 59 | 18 | 97.8% | 4.02 |
| | | | | | | 4-3 | 54% | Center portion | $3.76\times10^{17}$ | $6.66\times10^{18}$ | $3.74\times10^{18}$ | $1.20\times10^{17}$ | 32% | 93 | 23 | 96.4% | 4.27 |
| | | | | | | 4-4 | 83% | Tail side | $4.13\times10^{17}$ | $1.18\times10^{19}$ | $3.85\times10^{18}$ | $1.32\times10^{17}$ | 32% | 109 | 67 | 97.6% | - |

EP 4 411 031 A1

(continued)

| Crystal number | Si charge amount wtppm | B$_2$O$_3$ | Stirring | InAs charge amount wtppm | In charge amount wtppm | Sample number | Position from straight body seed | Position | Si concentration cm$^{-3}$ | In concentration cm$^{-3}$ | B concentration cm$^{-3}$ | Carrier concentration cm$^{-3}$ | Activation rate carrier/Si | Average dislocation density cm$^{-2}$ | Maximum dislocation density mm$^{-2}$ | Proportion of area of region with zero dislocation density % | Absorption coefficient cm$^{-1}$ |
|---|---|---|---|---|---|---|---|---|---|---|---|---|---|---|---|---|---|
| 5 | 130 | 1 mol% | with | 2000 | 1,210 | 5-1 | 1% | Seed side | $1.04 \times 10^{18}$ | $3.87 \times 10^{18}$ | $5.84 \times 10^{18}$ | $3.32 \times 10^{17}$ | 32% | 101 | 27 | 922% | - |
| | | | | | | 5-2 | 30% | between seed side and center portion | $4.55 \times 10^{17}$ | $5.04 \times 10^{18}$ | $3.99 \times 10^{18}$ | $1.46 \times 10^{17}$ | 32% | 29 | 32 | 95.4% | - |
| | | | | | | 5-3 | 60% | Center portion | $4.40 \times 10^{17}$ | $7.21 \times 10^{18}$ | $3.94 \times 10^{18}$ | $1.41 \times 10^{17}$ | 32% | 136 | 76 | 93.5% | - |
| | | | | | | 5-4 | 89% | Tail side | $7.46 \times 10^{17}$ | $1.37 \times 10^{19}$ | $4.91 \times 10^{18}$ | $2.39 \times 10^{17}$ | 32% | 87 | 115 | 96.6% | - |

| Crystal number | Si charge amount wtppm | $B_2O_3$ Si | Stirring | InAs charge amount wtppm | In charge amount wtppm | Sample number | Position from straight body seed | Position | Si concentration $cm^{-3}$ | In concentration $cm^{-3}$ | B concentration $cm^{-3}$ | Carrier concentration $cm^{-3}$ | Activation rate carrier/Si | Average dislocation density $cm^{-2}$ | Maximum dislocation density $mm^{-2}$ | Proportion of area of region with zero dislocation density % | Absorption coefficient $cm^{-1}$ |
|---|---|---|---|---|---|---|---|---|---|---|---|---|---|---|---|---|---|
| 6 | 140 | 0 mol% | with | 2,000 | 1,210 | 6-1 | 1% | Seed side | $8.70 \times 10^{17}$ | $3.01 \times 10^{18}$ | $7.60 \times 10^{18}$ | $2.91 \times 10^{17}$ | 33% | 190 | 39 | 93.2% | 5.56 |
| | | | | | | 6-2 | 12% | between seed side and center portion | $1.07 \times 10^{18}$ | $4.17 \times 10^{18}$ | $5.93 \times 10^{18}$ | $2.14 \times 10^{17}$ | 20% | 180 | 48 | 94.2% | - |
| | | | | | | 6-3 | 30% | between seed side and center portion | $4.16 \times 10^{17}$ | $4.97 \times 10^{18}$ | $3.86 \times 10^{18}$ | $8.31 \times 10^{16}$ | 20% | 170 | 45 | 92.5% | 4.05 |
| | | | | | | 6-4 | 71% | between center portion and tail side | $1.08 \times 10^{17}$ | $8.91 \times 10^{18}$ | $2.89 \times 10^{18}$ | $2.16 \times 10^{16}$ | 20% | 246 | 60 | 91.3% | 4.18 |
| | | | | | | 6-5 | 89% | Tail side | $2.90 \times 10^{17}$ | $1.26 \times 10^{19}$ | $9.80 \times 10^{18}$ | $2.17 \times 10^{16}$ | 7% | 67 | 45 | 92.5% | 3.96 |

(continued)

| Crystal number | Si charge amount wtppm | B₂O₃ Si | Stirring | InAs charge amount wtppm | In charge amount wtppm | Sample number | Position from straight body seed | Position | Si concentration cm⁻³ | In concentration cm⁻³ | B concentration cm⁻³ | Carrier concentration cm⁻³ | Activation rate carrier/Si | Average dislocation density cm⁻² | Maximum dislocation density mm⁻² | Proportion of area of region with zero dislocation density % | Absorption coefficient cm⁻¹ |
|---|---|---|---|---|---|---|---|---|---|---|---|---|---|---|---|---|---|
| 7 | 130 | 1 mol% | with | 2,000 | 1,210 | 7-1 | 2% | Seed side | $6.12\times10^{17}$ | $3.67\times10^{18}$ | $4.49\times10^{18}$ | $3.47\times10^{17}$ | 57% | 13 | 3 | 99.6% | 5.16 |
| | | | | | | 7-2 | 36% | between seed side and center portion | $6.04\times10^{17}$ | $3.94\times10^{18}$ | $2.52\times10^{18}$ | $2.98\times10^{17}$ | 49% | - | 2 | 99.8% | 5.46 |
| | | | | | | 7-3 | 54% | Center portion | $4.26\times10^{17}$ | $6.08\times10^{18}$ | $3.90\times10^{18}$ | $1.56\times10^{17}$ | 37% | 13 | 3 | 99.8% | - |
| | | | | | | 7-4 | 74% | between center portion and tail side | $3.08\times10^{17}$ | $7.02\times10^{18}$ | $3.52\times10^{18}$ | $9.92\times10^{16}$ | 32% | - | 4 | 99.8% | 4.79 |

| Crystal number | Si charge amount wtppm | $B_2O_3$ Si concertration | Stirring | InAs charge amount wtppm | In charge amount wtppm | Sample number | Position from straight body seed | Portion | Si concentration cm$^{-3}$ | In concentration cm$^{-3}$ | B concentration cm$^{-3}$ | Carrier concentration cm$^{-3}$ | Activation rate carrier/Si | Average dislocation density cm$^{-2}$ | Maximum dislocation density mm$^{-2}$ | Proportion of area of region with zero dislocation density % | Absorption coefficient cm$^{-1}$ |
|---|---|---|---|---|---|---|---|---|---|---|---|---|---|---|---|---|---|
| 8 | 140 | 0 mol%% | with | 2,000 | 1,210 | 8-1 | 1% | Seed side | $9.90 \times 10^{17}$ | $3.91 \times 10^{18}$ | $5.69 \times 10^{18}$ | $2.28 \times 10^{17}$ | 23% | 128 | 32 | 91.5% | 5.60 |
| | | | | | | 8-2 | 42% | Center portion | $1.57 \times 10^{17}$ | $5.78 \times 10^{18}$ | $3.04 \times 10^{18}$ | $3.61 \times 10^{16}$ | 23% | 10 | 10 | 99.9% | - |
| | | | | | | 8-3 | 62% | between center portion and tail side | $6.34 \times 10^{16}$ | $7.53 \times 10^{18}$ | $2.75 \times 10^{18}$ | $1.46 \times 10^{16}$ | 23% | 65 | 60 | 98.0% | 5.36 |
| | | | | | | 8-4 | 83% | Tail side | $1.59 \times 10^{17}$ | $1.13 \times 10^{19}$ | $3.05 \times 10^{18}$ | $3.65 \times 10^{16}$ | 23% | 35 | 36 | 98.8% | 4.78 |

EP 4 411 031 A1

| Crystal number | Si charge amount wtppm | $B_2O_3$ Si concertration | Stirring | InAs charge amount wtppm | In charge amount wtppm | Sample number | Position from straight body seed | Portion | Si concentration $cm^{-3}$ | In concentration $cm^{-3}$ | B concentration $cm^{-3}$ | Carrier concentration $cm^{-3}$ | Activation rate carrier/Si | Average dislocation density $cm^{-2}$ | Maximum dislocation density $mm^{-2}$ | Proportion of area of region with zero dislocation density % | Absorption coefficient $cm^{-1}$ |
|---|---|---|---|---|---|---|---|---|---|---|---|---|---|---|---|---|---|
| 9 | 130 | 0.25 mol% | with | 2,000 | 1,210 | 9-1 | 1% | Seed side | $8.89\times10^{17}$ | $3.91\times10^{18}$ | $5.36\times10^{18}$ | $2.04\times10^{17}$ | 23% | 133 | 30 | 95.0% | - |
| | | | | | | 9-2 | 12% | between seed side and center portion | $7.44\times10^{17}$ | $4.27\times10^{18}$ | $4.91\times10^{18}$ | $1.71\times10^{17}$ | 23% | 104 | 22 | 99.5% | - |
| | | | | | | 9-3 | 41% | Center portion | $4.68\times10^{17}$ | $5.69\times10^{18}$ | $4.03\times10^{18}$ | $1.08\times10^{17}$ | 23% | 86 | 38 | 95.6% | - |
| | | | | | | 9-4 | 61% | between center portion and tail side | $1.84\times10^{17}$ | $7.37\times10^{18}$ | $3.13\times10^{18}$ | $4.23\times10^{16}$ | 23% | 83 | 59 | 93.8% | - |
| | | | | | | 9-5 | 81% | Tail side | $2.86\times10^{17}$ | $1.10\times10^{19}$ | $3.45\times10^{18}$ | $6.57\times10^{16}$ | 23% | 99 | 79 | 94.7% | - |

The meaning of "-" is being not measured.

The conductivity type of the obtained GaAs ingots is n-type. From Crystal numbers 2 to 9 that underwnet crystal growth by stirring boric oxide so that the silicon concentration at the centre portion of the straight body portion was lower than the silicon concentration at the seed side of the straight body portion of the GaAs ingot, a plurality of wafers having a silicon concentration of $1.0 \times 10^{17}$ cm$^{-3}$ or more and less than $1.1 \times 10^{18}$ cm$^{-3}$, an indium concentration of $3.0 \times 10^{18}$ cm$^{-3}$ or more and less than $3.0 \times 10^{19}$ cm$^{-3}$, and a boron concentration of $2.5 \times 10^{18}$ cm$^{-3}$ or more, having a carrier concentration of $1.0 \times 10^{16}$ cm$^{-3}$ or more and $4.0 \times 10^{17}$ cm$^{-3}$ or less, and having a proportion of the area of a region with zero dislocation density to the wafer surface of 91.0% or more could be obtained from at least a part of the GaAs ingot.

INDUSTRIAL APPLICABILITY

According to this disclosure, it is possible to provide a GaAs wafer and a GaAs wafer group that have suppressed carrier concentration and low dislocation density, as well as a large proportion of the area of a region with zero dislocation density to the GaAs wafer surface, and thus are suitable for the substrate of the surface-emitting laser including a vertical cavity surface-emitting laser (VCSEL). According to this disclosure, it is also possible to provide a method of producing a GaAs ingot, from which the GaAs wafer and the GaAs wafer group can be obtained.

REFERENCE SIGNS LIST

| | |
|---|---|
| 1 | heater |
| 2 | crucible housing container (susceptor) |
| 3 | crucible |
| 4 | sealant ($B_2O_3$) |
| 5 | compound semiconductor raw materials |
| 6 | seed crystal |
| 7 | air tight container |
| 8 | inert gas |
| 9 | GaAs polycrystalline raw materials |
| 10 | dopant (silicon) |
| 11 | dopant (indium) |
| 14 | mechanism for moving up and down and rotating the crucible |
| 15 | position at which the cone portion changes to the straight body portion |
| 16 | midpoint position between the position 15 and the position 17 |
| 17 | position at which the straight body portion ends |
| 18 | straight body portion of the GaAs ingot |
| 19 | cone portion of the GaAs ingot |
| 20 | stirring blade |
| 21 | upper rod |
| 30 | 6-inch wafer |
| 31 | area |

**Claims**

1. A GaAs wafer having:

   a silicon concentration of $1.0 \times 10^{17}$ cm$^{-3}$ or more and less than $1.1 \times 10^{18}$ cm$^{-3}$;
   an indium concentration of $3.0 \times 10^{18}$ cm$^{-3}$ or more and less than $3.0 \times 10^{19}$ cm$^{-3}$;
   a boron concentration of $2.5 \times 10^{18}$ cm$^{-3}$ or more;
   a carrier concentration of $1.0 \times 10^{16}$ cm$^{-3}$ or more and $4.0 \times 10^{17}$ cm$^{-3}$ or less; and
   a proportion of the area of a region with zero dislocation density to the whole surface of the wafer of 91.0% or more,
   wherein the proportion of the area of a region with zero dislocation density to the whole surface of the wafer is expressed as a proportion of the number of areas where the number of etch pit counts is 0 to the total number of areas, when, after the wafer surface is pretreated with a sulfuric acid mirror etchant ($H_2SO_4$:$H_2O_2$:$H_2O$ = 3:1:1 (volume ratio)), the wafer surface is immersed in a KOH melt with a liquid temperature of 320°C for 35 minutes to generate etch pits on the wafer surface, a region excluding a toric part with a width of 3 mm from the outer periphery toward the center of the wafer surface from the whole surface of the wafer surface is divided into areas of 1 mm square, and the entire range of each area is then observed with a microscope to count the number of etch pits.

2. The GaAs wafer according to claim 1, having an average dislocation density of 250 cm$^{-2}$ or less, wherein the average dislocation density is expressed by a value obtained by, after pretreating the wafer surface with a sulfuric acid mirror etchant ($H_2SO_4$:$H_2O_2$:$H_2O$ = 3:1:1 (volume ratio)), immersing the wafer surface in a KOH melt with a liquid temperature of 320°C for 35 minutes to generate etch pits on the wafer surface, setting 69 or 37 areas with a diameter of 3 mm at regular intervals on the whole surface of the wafer surface, observing each area with a microscope with a field of view diameter of 1.73 mm, searching the field of view where the maximum number of etch pits are observed to count the number of etch pits, determining a converted value obtained by converting the number of counts into a value per unit area (cm$^{-2}$), and then averaging the converted values of the respective areas.

3. The GaAs wafer according to claim 1 or 2, wherein the wafer has a size of 3 inches or more.

4. A GaAs wafer group comprising a plurality of GaAs wafers obtained from a straight body portion of an identical GaAs ingot,
wherein each of the plurality of GaAs wafers has:

a silicon concentration of $1.0 \times 10^{17}$ cm$^{-3}$ or more and less than $1.1 \times 10^{18}$ cm$^{-3}$;
an indium concentration of $3.0 \times 10^{18}$ cm$^{-3}$ or more and less than $3.0 \times 10^{19}$ cm$^{-3}$;
a boron concentration of $2.5 \times 10^{18}$ cm$^{-3}$ or more;
a carrier concentration of $1.0 \times 10^{16}$ cm$^{-3}$ or more and $4.0 \times 10^{17}$ cm$^{-3}$ or less; and
a proportion of the area of a region with zero dislocation density to the whole surface of the wafer of 91.0% or more, and
the proportion of the area of a region with zero dislocation density to the whole surface of the wafer is expressed as a proportion of the number of areas where the number of etch pit counts is 0 to the total number of areas, when, after the wafer surface is pretreated with a sulfuric acid mirror etchant ($H_2SO_4$:$H_2O_2$:$H_2O$ = 3:1:1 (volume ratio)), the wafer surface is immersed in a KOH melt with a liquid temperature of 320°C for 35 minutes to generate etch pits on the wafer surface, a region excluding a toric part with a width of 3 mm from the outer periphery toward the center of the wafer surface from the whole surface of the wafer surface is divided into areas of 1 mm square, and the entire range of each area is then observed with a microscope to count the number of etch pits.

5. The GaAs wafer group according to claim 4, wherein each of the plurality of GaAs wafers has an average dislocation density of 250 cm$^{-2}$ or less, and
the average dislocation density is expressed by a value obtained by, after pretreating the wafer surface with a sulfuric acid mirror etchant ($H_2SO_4$:$H_2O_2$:$H_2O$ = 3:1:1 (volume ratio)), immersing the wafer surface in a KOH melt with a liquid temperature of 320°C for 35 minutes to generate etch pits on the wafer surface, setting 69 or 37 areas with a diameter of 3 mm at regular intervals on the whole surface of the wafer surface, observing each area with a microscope with a field of view diameter of 1.73 mm, searching the field of view where the maximum number of etch pits are observed to count the number of etch pits, determining a converted value obtained by converting the number of counts into a value per unit area (cm$^{-2}$), and then averaging the converted values of the respective areas.

6. The GaAs wafer group according to claim 5, wherein the plurality of GaAs wafers are obtained from a center portion of the straight body portion of the GaAs ingot and include a wafer having a carrier concentration of less than $2.0 \times 10^{17}$ cm$^{-3}$.

7. The GaAs wafer group according to any one of claims 4 to 6, wherein the plurality of wafers are half or more of the total number of wafers obtained from the straight body portion of the identical GaAs ingot.

8. The GaAs wafer group according to claim 7, wherein the plurality of wafers are the total number of wafers obtained from a seed side to a tail side of the straight body portion of the identical GaAs ingot.

9. A method of producing a GaAs ingot by a vertical gradient freezing method or a vertical Bridgman method, the method using silicon and indium as dopants and using boric oxide as a sealant,
wherein the boric oxide is stirred to lower the silicon concentration at a center portion of a straight body portion of the GaAs ingot than the silicon concentration at a seed side of the straight body portion to cause crystal growth.

10. The method of producing a GaAs ingot according to claim 9, wherein the amount of the silicon to be charged is 110 wtppm or more and 150 wtppm or less, and the amount of the indium to be charged is 1000 wtppm or more and 5000 wtppm or less, with respect to the amount of GaAs to be charged into a furnace.

11. The method of producing a GaAs ingot according to claim 9, wherein the amount of the silicon to be charged is 120 wtppm or more and 140 wtppm or less, and the boric oxide contains silicon with 2 mol% or less.

12. The method of producing a GaAs ingot according to claim 9, wherein the stirring has a stirring rate that increases from the seed side toward a tail side of the straight body portion to make the maximum stirring rate 6 rpm or more.

13. The method of producing a GaAs ingot according to claim 9, wherein the silicon concentration at the seed side of the straight body portion is $7.0 \times 10^{17}$ cm$^{-3}$ or more, and the silicon concentration at the center portion of the straight body portion is $6.0 \times 10^{17}$ cm$^{-3}$ or less.

14. The method of producing a GaAs ingot according to claim 9, wherein the carrier concentration at the seed side of the straight body portion of the GaAs ingot is greater than the carrier concentration at the tail side of the straight body portion.

15. The method of producing a GaAs ingot according to any one of claims 9 to 14, wherein the center portion of the straight body portion of the GaAs ingot has a part having a carrier concentration of less than $2.0 \times 10^{17}$ cm$^{-3}$.

# FIG. 1

# FIG. 2

# FIG. 3

# FIG. 4

## INTERNATIONAL SEARCH REPORT

| International application No. |
| --- |
| **PCT/JP2022/035510** |

**A. CLASSIFICATION OF SUBJECT MATTER**

*C30B 29/42*(2006.01)i; *C30B 29/40*(2006.01)i
FI: C30B29/42; C30B29/40 A; C30B29/40 501C

According to International Patent Classification (IPC) or to both national classification and IPC

**B. FIELDS SEARCHED**

Minimum documentation searched (classification system followed by classification symbols)
C30B29/42; C30B29/40

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2003-206200 A (HITACHI CABLE LTD) 22 July 2003 (2003-07-22)<br>entire text, all drawings | 1-15 |
| A | JP 64-9898 A (NIPPON MINING CO LTD) 13 January 1989 (1989-01-13)<br>entire text, all drawings | 1-15 |
| A | JP 2012-246156 A (DOWA ELECTRONICS MATERIALS CO LTD) 13 December 2012 (2012-12-13)<br>entire text, all drawings | 1-15 |
| P, A | WO 2021/251349 A1 (DOWA ELECTRONICS MATERIALS CO LTD) 16 December 2021 (2021-12-16)<br>entire text, all drawings | 1-15 |

☐ Further documents are listed in the continuation of Box C.  ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **25 November 2022** | **06 December 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/035510**

| Patent document cited in search report | | | Publication date (day/month/year) | Patent family member(s) | | | Publication date (day/month/year) |
|---|---|---|---|---|---|---|---|
| JP | 2003-206200 | A | 22 July 2003 | (Family: none) | | | |
| JP | 64-9898 | A | 13 January 1989 | (Family: none) | | | |
| JP | 2012-246156 | A | 13 December 2012 | US | 2014/0205527 | A1 | |
| | | | | entire text, all drawings | | | |
| | | | | WO | 2012/160781 | A1 | |
| | | | | DE | 112012002217 | B | |
| | | | | TW | 201250073 | A | |
| | | | | SG | 195154 | A | |
| | | | | CN | 103703172 | A | |
| | | | | KR | 10-2014-0044831 | A | |
| | | | | TW | 201704569 | A | |
| WO | 2021/251349 | A1 | 16 December 2021 | JP | 2022-8146 | A | |
| | | | | TW | 202204704 | A | |

Form PCT/ISA/210 (patent family annex) (January 2015)

**EP 4 411 031 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011148693 A

- JP 2015078122 A

**Non-patent literature cited in the description**

- *Refractive Index of GaAs_Journal of Applied Physics,* 1964